(19) Europäisches Patentamt
European Patent Office
Office européen des brevets

(11) **EP 3 417 299 B1**

(12) **EUROPÄISCHE PATENTSCHRIFT**

(45) Veröffentlichungstag und Bekanntmachung des Hinweises auf die Patenterteilung:
**04.09.2024 Patentblatt 2024/36**

(21) Anmeldenummer: **17704212.4**

(22) Anmeldetag: **07.02.2017**

(51) Internationale Patentklassifikation (IPC):
**G01J 9/04** *(2006.01)*    **G01R 23/17** *(2006.01)*
**G01J 3/42** *(2006.01)*    **G01J 1/44** *(2006.01)*
**H04B 10/64** *(2013.01)*    *G01R 23/165* *(2006.01)*

(52) Gemeinsame Patentklassifikation (CPC):
**G01J 3/42; G01J 9/04; G01R 23/17;** G01R 23/165

(86) Internationale Anmeldenummer:
**PCT/EP2017/052606**

(87) Internationale Veröffentlichungsnummer:
**WO 2017/140529 (24.08.2017 Gazette 2017/34)**

(54) **SPEKTRUMANALYSATOR UND VERFAHREN ZUR SPEKTRALANALYSE**

SPECTRUM ANALYZER AND METHOD FOR SPECTRAL ANALYSIS

ANALYSEUR DE SPECTRE ET PROCÉDÉ D'ANALYSE SPECTRALE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.02.2016 DE 102016102818**

(43) Veröffentlichungstag der Anmeldung:
**26.12.2018 Patentblatt 2018/52**

(73) Patentinhaber: **Technische Universität Darmstadt 64289 Darmstadt (DE)**

(72) Erfinder: **PREU, Sascha 64289 Darmstadt (DE)**

(74) Vertreter: **LifeTech IP Spies & Behrndt Patentanwälte PartG mbB Elsenheimerstraße 47a 80687 München (DE)**

(56) Entgegenhaltungen:
DE-A1- 3 643 569    DE-T2- 69 125 254
US-A1- 2012 044 479    US-B1- 6 348 683

- YAN ZHIZHONG ET AL: "Optoelectronic mixing in NbN superconducting nanowire single photon detectors", PROCEEDINGS OF SPIE, vol. 7386, 10 June 2009 (2009-06-10), XP055834772, ISSN: 0277-786X, DOI: 10.1117/12.844358
- ANONYMOUS: "Spektrumanalysator - Wikipedia", 6 October 2015 (2015-10-06), pages 1 - 6, XP055373440, Retrieved from the Internet <URL:https://de.wikipedia.org/w/index.php?title=Spektrumanalysator&oldid=146752421> [retrieved on 20170516]
- SHUKO YOKOYAMA ET AL: "Terahertz spectrum analyzer based on a terahertz frequency comb", OPTICS EXPRESS, vol. 16, no. 17, 18 August 2008 (2008-08-18), pages 13052, XP055371899, DOI: 10.1364/OE.16.013052
- PREU S ET AL: "Tunable, continuous-wave Terahertz photomixer sources and applications", JOURNAL OF APPLIED PHYSICS, AMERICAN INSTITUTE OF PHYSICS, US, vol. 109, no. 6, 22 March 2011 (2011-03-22), pages 61301 - 61301, XP012147713, ISSN: 0021-8979, DOI: 10.1063/1.3552291
- ROLLAND ANTOINE ET AL: "Narrow Linewidth Tunable Terahertz Radiation By Photomixing Without Servo-Locking", IEEE TRANSACTIONS ON TERAHERTZ SCIENCE AND TECHNOLOGY, IEEE, PISCATAWAY, NJ, USA, vol. 4, no. 2, 1 March 2014 (2014-03-01), pages 260 - 266, XP011542423, ISSN: 2156-342X, [retrieved on 20140307], DOI: 10.1109/TTHZ.2013.2296144

**EP 3 417 299 B1**

**Beschreibung**

Die vorliegende Erfindung bezieht sich auf einen Spektrumanalysator und ein Verfahren zur Spektralanalyse und insbesondere auf einen photonischen Dauerstrich-Spektrumanalysator.

Hintergrund

Spektrumanalysatoren sind wichtige Instrumente zur Charakterisierung elektromagnetische Quellen oder entsprechender Emissions- oder Absorptionseigenschaften von Stoffen. Zunehmend interessant wird der Terahertz- (THz-) Frequenzbereich, der Frequenzen in einem Bereich von beispielsweise 100 GHz bis zu 10 THz oder mehr umfasst. Bisher ist dieser Spektralbereich im elektromagnetischen Spektrum zwischen dem Gleichstrom und Röntgenstrahlung nur unzureichend erschlossen.

Auf der anderen Seite findet die THz-Spektrumanalyse auf vielen technischen Gebieten Anwendung. Insbesondere besteht ein Bedarf nach Möglichkeiten breitbandige THz Signale (beispielsweise schwarzer Strahler) zu charakterisieren. Außerdem ist es wünschenswert, Frequenzvervielfacherketten bezüglich unerwünschten höheren Ordnungen der Vervielfachung zu charakterisieren. Ferner besteht ein Bedarf nach Messungen der Seitenbandenunterdrückung von THz Quellen. Darüber hinaus ist eine effiziente THz Spektroskopie nützlich, um Gase oder andere Inhaltsstoffe zu detektieren. Beispielsweise können Umweltschutzanforderungen hinsichtlich bestimmter Gase in der Atmosphäre über die THz Spektroskopie durchgeführt werden. Ebenso spielt die THz Spektroskopie in der Astronomie eine wichtige Rolle. Die spektrale Reinheit bekannter THz Spektroskopiesysteme ist allerdings wenig untersucht. Häufig verlässt man sich darauf, dass die spektralen Eigenschaften der zur Erzeugung der THz-Welle herangezogen Laser oder RF Oszillatoren, sich direkt und ohne Modifikation durch den Konversionsprozess auf das THz Signal übertragen. Eine weitere wichtige Anwendung besteht im Mobilfunk, der sich zunehmend zu höheren Frequenzen hin zu dem THz Bereich entwickelt. Ebenso wichtig sind spektrale Analysen für Nachrichtenübertragungen über Glasfaserleitungen. Schließlich kann die THz Spektroskopie für Sicherheitschecks (beispielsweise am Flughafen) genutzt werden.

Leider gibt es bisher nur wenige und aufwendige Ansätze, einen Spektrumanalysator für diesen Frequenzbereich zu verwirklichen.

Ein bekanntes System beruht auf die frequenzvervielfachten Netzwerkanalysatoren, die wegen ihrer hohen Anschaffungskosten bisher im Wesentlichen nur im wissenschaftlichen Bereich als Spektralanalysatoren genutzt werden. Eine Alternative sind photonische Systeme, die auf Frequenzkämmen beruhen, also kurzpulsigen Lasern mit einer Wiederholrate von $f_{rep}$, die auf einen stabilen Frequenzstandard wie beispielsweise einer Atomuhr oder einem Wasserstoffmaser fest eingestellt sind, wodurch das Modenspektrum des Lasers stabilisiert wird. Da nur ausgewählte Frequenzen ($fn = f0 + n*f_{rep}$ , wobei n eine natürliche Zahl ist) mit einem Abstand in der Widerholrate emittiert werden, entsteht ein "Kamm" von Frequenzen, der in einem Photomischer heruntergemischt werden kann. Der Photomischer kann beispielsweise als ein Halbleiterbauteil, das die Laserstrahlung absorbiert, umgesetzt sein. Der Photomischer erzeugt beim Mischen Differenzfrequenzen aller Linien und somit einen Frequenzkamm im Terahertzbereich mit einem Linienabstand von $f_{rep}$. Durch eine geeignete Wahl der Wiederholfrequenz sowie eines genügend breiten Modenspektrums des Lasers ist es möglich, viele Terahertzfrequenzen zu erzeugen.

Dieses Signal dient als ein Lokaloszillator und wird in einem Terahertzdetektor mit der zu analysierenden Strahlung gemischt. Durch den Mischvorgang entsteht eine niederfrequente Schwebung (im Radiofrequenz-Bereich) bei der Differenzfrequenz des Signals und des Terahertzfrequenzkamms. Dieser Vorgang ist ebenfalls als ein Heruntermischen auf Frequenzen in der Größenordnung von $f_{rep}$ bekannt. Anschließend kann die Schwebung mit einem Radiofrequenz- (RF-) Spektralanalysator ausgewertet werden, so dass eine Charakterisierung der Linienbreite möglich wird. Zur genauen Frequenzbestimmung kann die Messung bei einer zweiten Pulswiederholrate $f_{rep}$' wiederholt werden, um herauszufinden, mit welcher Linie des TerahertzFrequenzkamms die Heruntermischung erfolgte.

Diese Technik ist zwar sehr akkurat und erlaubt eine Charakterisierung extrem schmalbandiger Quellen, allerdings können Signale, deren spektrale Breite größer ist als $f_{rep}$, nicht charakterisiert werden, da sie den freien Spektralbereich des Kamms überstrahlen. Zudem sind Frequenzkämme sehr aufwendig und kostenintensiv in ihrer Umsetzung in Spektralanalysatoren. Ein Terahertzspektrumanalysator basierend auf einer Frequenzkammanalyse ist in Shuko Yokoyama et al.: "Terahertz spectrum analyzer based on a terahertz frequency comb", Optics Express, Bd. 16, Nr. 17, 18, Seite 13052, offenbart.

DE 691 25 254 T2 beschreibt einen optischen Pulsoszillator und damit arbeitende Vorrichtung zur Lichtfrequenzmessung. D4 betrifft einen Analysator für optische Frequenzen. In "Tunable, continuous-wave Terahertz photomixer sources and applications", JOURNAL OF APPLIED PHYSICS, Bd. 109, Nr. 6 (2011-03-22), DOI: 10.1063/1.3552291 beschreiben Preu S et al. abstimmbare Terahertz-Photomixer-Quellen für astrophysikalische Untersuchungen. US 2012/044479 A1 beschreibt ein THz-Spektroskopiesystem zur optischen Analyse einer Probe.

Daher besteht ein Bedarf nach alternativen Möglichkeiten, eine Spektralanalyse im Terahertzbereich kostengünstig umzusetzen.

Zusammenfassung

Die oben genannte Aufgabe wird durch einen Spektrumanalysator nach Anspruch 1 und ein Verfahren zur Spektralanalyse nach Anspruch 12 gelöst. Die abhängigen Ansprüche beziehen sich auf vorteilhafte Weiterbildungen der Gegenstände vom Anspruch 1 und Anspruch 12.

Die vorliegende Erfindung bezieht sich auf einen Spektrumanalysator für (bzw. Vorrichtung, die ausgebildet ist zur) Spektralanalyse eines elektromagnetischen Messsignals unter Nutzung eines Mischers oder opto-elektronischen Mischers oder Photomischers. Ein opto-elektronischer Mischer kann als ein Mischer angesehen werden, der ein optisches oder elektromagnetisches Signal mit einem THz Signal zu einer niedrigen Frequenz heruntermischt. Der opto-elektronische Mischer ist ausgebildet, um ein elektrisches Überlagerungssignal durch eine Überlagerung des elektromagnetischen Messsignals und eines Referenzsignals (z.B. ein optisches) mit zumindest einer bekannten Frequenz zu erzeugen. Die Vorrichtung umfasst die folgenden Merkmale: ein Signaleingang zum Empfangen des elektrischen Überlagerungssignals von dem opto-elektronischen Mischer und ein Tiefpassfilter, der ausgebildet ist, um aus dem elektrischen Überlagerungssignal ein gefiltertes Überlagerungssignal durch ein Herausfiltern von Frequenzanteilen oberhalb einer oberen Grenzfrequenz zu erzeugen. Die Vorrichtung umfasst weiter einen Gleichrichter, der ausgebildet ist, um aus dem gefilterten Überlagerungssignal ein gleichgerichtetes Überlagerungssignal zu erzeugen, und eine Ausleseeinheit, die ausgebildet ist, um basierend auf dem gleichgerichteten Überlagerungssignal eine Übereinstimmung der bekannten Frequenz des Referenzsignals mit dem elektromagnetischen Messsignal festzustellen.

Im Rahmen der vorliegenden Erfindung soll der Begriff "Übereinstimmung" nicht zwingend eine genaue Gleichheit definieren. Vielmehr können bei der Feststellung der Übereinstimmung Toleranzen in der Größe der Bandbreite des Tiefpasses akzeptiert werden.

Auch unter einem Gleichrichter soll jedes Bauelement umfasst sein, das eine gleichrichtende Eigenschaft aufweist. Dazu gehören nicht nur verschiedene Dioden, sondern auch Präzisionsgleichrichter oder Operationsverstärkerschaltungen, die auch eine Gleichrichtung bewirken. Als Präzisionsgleichrichter können insbesondere solche Gleichrichter genutzt werden, die die von den Dioden bekannten Nichtlinearitäten in der Kennlinie (z.B. die stromstärkeabhängige Durchlassspannung) nicht aufweisen - oder zumindest nicht in dem THz Frequenzbereich. Bei der Verwendung von Hochfrequenzdioden (z.B. Schottky-Dioden) ohne Operationsverstärker oder Operationsverstärkern mit geringer Verstärkung funktioniert das erfindungsgemäße Konzept als ein Leistungsmessgerät (statt der Messung von THz Feldstärke), da in dem hier interessanten Leistungsbereich die Linearität nicht gegeben ist (der Arbeitspunkt liegt außerhalb des linearen Bereiches).

Der opto-elektronische Mischer, der Teil der Vorrichtung zur Spektralanalyse ist, erzeugt als elektrisches Überlagerungssignal insbesondere ein Signal mit einer Frequenz, die die Differenz der Referenzsignalfrequenz und der Frequenz des elektromagnetischen Messsignals ist. Das Referenzsignal kann selbst ein Differenzsignal sein, d.h. durch eine Überlagerung von zwei beispielhaften Lasersignalen erzeugt werden, so dass die Differenz dieser beiden Frequenzen für die Spektralanalyse genutzt werden kann.

Die definierte Vorrichtung erlaubt es durch den Gleichrichter festzustellen, ob eine bestimmte Frequenz des elektromagnetischen Messsignals (oder ein Frequenzanteil des Messsignals) innerhalb des Frequenzbandes des Tiefpassfilters liegt oder ob in dem durch den Tiefpassfilter ausgewählten Frequenzband nur Rauschen vorliegt. Mit dem Gleichrichter kann der Einfluss einer unbekannten Phasenlage eliminiert werden, so dass unabhängig von der Phasenlage der einzelnen Signale ein Signal genau ausgelesen werden kann.

Durch ein gezieltes Verstimmen des Referenzsignals kann außerdem das gesamte Spektrum des Messsignals durchlaufen werden. Da die Referenzsignalfrequenz bekannt ist, kann somit das Spektrum des elektromagnetischen Messsignals durch eine Variation der Referenzsignalfrequenz verbunden mit einer Tiefpassfilterung ermittelt werden. Der Gleichrichter und die Ausleseeinheit können dabei sowohl ein Detektionssignal (Bestätigung des Vorhandenseins einer bestimmten Frequenz) als auch die entsprechende Stärke dieses Frequenzbereiches bestimmen.

Bei weiteren Ausführungsbeispielen umfasst die Vorrichtung weiter einen Verstärker, um das elektrische Überlagerungssignal und/oder das gefilterte Überlagerungssignal und/oder das gleichgerichtete Überlagerungssignal zu verstärken.

Bei weiteren Ausführungsbeispielen weist der Verstärker eine geringere Verstärkung für Signale mit Frequenzen oberhalb der Grenzfrequenz auf, so dass der Tiefpassfilter Teil des Verstärkers sein kann. Wenn der Verstärker frequenzabhängig verstärkt, braucht somit nicht notwendigerweise der Tiefpassfilter als separates Bauelement ausgebildet sein. Beispielsweise kann der Verstärker lediglich Frequenzen in einem bestimmten Frequenzbereich verstärken, so dass oberhalb dieses Frequenzbandes keine Verstärkung stattfindet und er somit effektiv als ein Tiefpassfilter wirkt.

Bei weiteren Ausführungsbeispielen ist der Tiefpassfilter ausgebildet, um ansprechend auf ein Steuersignal die Grenzfrequenz zu ändern. Dieses Ausführungsbeispiels bietet den Vorteil, dass zunächst ein entsprechend breitbandiger Tiefpassfilter eine grobe Spektralanalyse des elektromagnetischen Messsignals durchführen kann. Daran anschließend kann der Tiefpassfilter entsprechend eng gewählt werden, so dass eine Feinbestimmung des Frequenzanteils in dem elektromagnetischen Messsignal möglich wird.

Bei weiteren Ausführungsbeispielen umfasst die Vorrichtung weiter einen Lock-in-Verstärker und/oder einen Modulator (z.B. einen Chopper) zum Modulieren des Referenzsignals (oder eines Teils davon) mit einem Signal bekannter Frequenz und/oder Phase. Die Ausleseeinheit kann ausgebildet sein, um aus dem resultierenden elektrischen Überlagerungssignal basierend auf der Lock-In-Technik die Detektion durchzuführen. In weiteren Ausführungsbeispielen kann auch das elektromagnetische Messsignal mit einem bekannten Signal moduliert werden, um unter Nutzung eines Lock-In-Verstärkers gezielt eine Verstärkung eines bestimmten Frequenzanteils zu ermöglichen.

Bei weiteren Ausführungsbeispielen umfasst die Vorrichtung weiter einen Hochpassfilter, der ausgebildet ist, um Frequenzanteile des elektrischen Überlagerungssignals, die unterhalb einer unteren Grenzfrequenz liegen, herauszufiltern, wobei der Hochpassfilter entlang eines Signalpfades vor dem Gleichrichter ausgebildet sein kann. Dieses Ausführungsbeispiel bietet den Vorteil, dass niederfrequentes Rauschen (z.B. 1/f Rauschen) bzw. unerwünschte Gleichstromsignale gezielt herausgefiltert werden kann.

Bei weiteren Ausführungsbeispielen hängt die obere Grenzfrequenz des Tiefpassfilters von einer Linienbreite des Referenzsignals ab bzw. ist dadurch gegeben (mit einer beispielhaften Toleranzbreite von $\pm$ 10% oder $\pm$ 50%).

Die vorliegende Erfindung bezieht sich auch auf einen Spektrumanalysator für ein elektromagnetisches Messsignal, wobei der Spektrumanalysator eine Referenzsignalquelle mit den zuvor beschriebenen Eigenschaften, einen der zuvor beschriebenen opto-elektronischen Mischer und eine der zuvor genannten Vorrichtungen umfasst.

Der Spektrumanalysator umfasst: eine Laserquelle, die ausgebildet ist, ein erstes Dauerstrichlasersignal mit einer ersten Frequenz und zweites Dauerstrichlasersignal mit einer zweiten Frequenz zu erzeugen und zu dem Referenzsignal zu kombinieren. Der Spektrumanalysator umfasst weiter einen opto-elektronischen Mischer, der ausgebildet ist, um ein elektrisches Überlagerungssignal durch eine Überlagerung des elektromagnetischen Messsignals und des Referenzsignals zu erzeugen. Schließlich umfasst der Spektrumanalysator eine der zuvor beschriebenen Vorrichtungen. Die bekannte Frequenz des Referenzsignals entspricht beispielsweise der Differenz der ersten Frequenz und der zweiten Frequenz oder kann mit der Differenz der ersten Frequenz und der zweiten Frequenz bis auf eine bekannte Verstimmung übereinstimmen. Die Überlagerung der beiden Lasersignale ergibt sich beispielsweise aus einer Addition (Superposition) der beiden Signale.

Durch die Mischung mit dem Referenzsignal und die Tiefpassfilterung ist sichergestellt, dass nur Frequenzen, die mit der Referenzfrequenz übereinstimmen bzw. sich maximal um die vom Tiefpassfilter festgelegte Frequenz unterscheiden, gemessen werden können.

Die Laserquelle ist durchstimmbar, um die erste Frequenz und/oder zweite Frequenz in einem vorbestimmten Bereich zu ändern, wobei der vorbestimmte Bereich insbesondere Frequenzen von 0 bis 10 THz umfasst. Das erste Lasersignal und/oder das zweite Lasersignal ist beispielsweise derart durchstimmbar, dass eine Differenzfrequenz zwischen dem ersten Lasersignal und dem zweiten Lasersignal in einem Bereich bis zu 10 THz (oder mehr) liegt.

Bei weiteren Ausführungsbeispielen umfasst das erste Lasersignal und/oder das zweite Lasersignal eine Wellenlänge in einem Bereich zwischen 500 nm und 1700 nm.

Bei weiteren Ausführungsbeispielen umfasst der opto-elektronische Mischer gegenüberliegende Fingerkontakte, die eine Fingerkontaktelektrodenstruktur bilden, wobei ein (maximaler) Abstand zwischen den Fingerkontakten von weniger als 20 $\mu$m ausgebildet sein kann. An den gegenüberliegenden Fingerkontakten kann das elektrische Überlagerungssignal abgenommen werden. Dazu kann beispielsweise eine Spannung an den Fingerkontakten angelegt werden, so dass ein Stromfluss wegen der strahlungsabhängigen Änderung der Leitfähigkeit von dem elektromagnetischen Messsignal und dem Referenzsignal abhängt. Es versteht sich, dass die Fingerkontaktelektrodenstruktur nur ein Beispiel darstellt. Bei weiteren Ausführungsbeispielen kann die Kontaktierung auch andere Elektrodenformen aufweisen. Außerdem können auch andere Photoleitertypen (z.B. plasmonische Photoleiter) oder andere Bauformen von opto-elektronischen Mischern Anwendung finden.

Bei weiteren Ausführungsbeispielen umfasst der opto-elektronische Mischer eine Antenne zum Empfangen des elektromagnetischen Messsignals und/oder eine Linse zum Fokussieren des elektromagnetischen Messsignals.

Bei weiteren Ausführungsbeispielen ist die Laserquelle zur Erzeugung des ersten Lasersignals und des zweiten Lasersignals eine Multimoden Laserquelle. Damit können durch eine einzige Quelle beide optischen Signale erzeugt werden.

Die vorliegende Erfindung bezieht sich auch auf ein Verfahren zur Spektralanalyse eines elektromagnetischen Messsignals unter Nutzung eines opto-elektronischen Mischer. Der opto-elektronische Mischer ist ausgebildet, um das elektrische Überlagerungssignal durch eine Überlagerung des elektromagnetischen Messsignals und eines Referenzsignals mit zumindest einer bekannten Frequenz zu erzeugen. Das Verfahren umfasst die folgenden Schritte: Empfangen eines elektrischen Überlagerungssignals von dem opto-elektronischen Mischer, Erzeugen eines gefilterten Überlagerungssignals aus dem elektrischen Überlagerungssignal durch ein Tiefpassfiltern, um Frequenzanteile oberhalb einer oberen Grenzfrequenz herauszufiltern. Außerdem umfasst das Verfahren ein Erzeugen eines gleichgerichteten Überlagerungssignals durch ein Gleichrichten des gefilterten Überlagerungssignals und ein Feststellen einer Übereinstimmung der bekannten Frequenz des Referenzsignals mit dem elektromagnetischen Messsignal. Der letzte Schritt kann durch ein Detektieren eines Gleichspannungssignals in dem gleichgerichteten Überlagerungssignal erfolgen.

Bei weiteren Ausführungsbeispielen ist das Referenzsignal eine Schwebung von zwei Lasersignalen, die von einer oder mehreren Laserquellen erzeugt werden, und das Verfahren umfasst weiter: Durchstimmen von zumindest einer der Laserquellen bis eine Frequenz eines Teils des Überlagerungssignals unterhalb der Grenzfrequenz des Tiefpasses liegt, und Feststellen, dass das elektromagnetische Messsignal die Frequenz aufweist.

Ausführungsbeispiele der vorliegenden Erfindung lösen somit die obengenannte technische Aufgabe durch die Nutzung eines opto-elektronischen Mischer zur Mischung eines Referenzsignals im Terahertzbereich und des zu untersuchenden Messsignals, wobei ein anschließender Tiefpassfilter mit einer beispielhaften Abschneidefrequenz im Bereich der Linienbreite der Referenzsignalquellen (beispielsweise einige MHz) einen zu untersuchenden Frequenzbereich um die Frequenz der Schwebung im Referenzsignal auswählt. Der nachfolgende Gleichrichter erzeugt einen Gleichspannungsanteil, der einen Einfluss einer unbekannten Phasenlage eliminiert. Somit kann unabhängig von der Phasenlage der einzelnen Signale ein Signal genau dann ausgelesen werden, wenn das zu messende Messsignal eine Frequenz aufweist, die innerhalb des von dem Tiefpassfilter bereitgestellten Frequenzbandes liegt.

Im Vergleich zu konventionellen Spektrumanalysatoren bieten Ausführungsbeispiele der vorliegenden Erfindung Vorteile, da sie nicht auf den konventionellen Frequenzkammuntersuchungen basieren. Daher sind vergleichsweise aufwendige, gepulste Systeme, die auf einen Frequenzstandard fest eingestellt sind, nicht erforderlich. Außerdem wird gemäß der vorliegenden Erfindung keine Quelle für eine Terahertzstrahlung benötigt. Ausführungsbeispiele der vorliegenden Erfindung beruhen auf kostengünstigen Dauerstrichlaserquellen und nur einem Photomischer. Dies vereinfacht den Aufbau und kann kostengünstig gestaltet werden. Ein Lokaloszillator ist ebenso wenig erforderlich. Vielmehr werden die Lasersignale im Photomischer direkt gemischt, um so ein niederfrequentes Signal zu erzeugen. Diese Mischung dient zwar direkt als Lokaloszillator, es braucht aber kein Terahertzsignal separat erzeugt zu werden. Außerdem wird das Resultat der Mischung anschließend gleichgerichtet und direkt gemessen, ohne das Spektrum bei einer Zwischenfrequenz auswerten zu müssen. Weitere Vorteile der vorliegenden Erfindung bestehen darin, dass Dauerstrichlaser über einen breiten Bereich durchstimmbar sind, kostengünstig sind, und der Spektrumanalysatoraufbau prinzipiell kompatibel mit gängigen Photomischsystemen ist.

## Kurzbeschreibung der Figuren

Die Ausführungsbeispiele der vorliegenden Erfindung werden besser verstanden von der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränkt, sondern lediglich der Erklärung und dem Verständnis dienen.

Fig. 1    zeigt eine Vorrichtung zur Spektralanalyse des elektromagnetischen Messsignals gemäß einem Ausführungsbeispiel der vorliegenden Erfindung.

Fig. 2    veranschaulicht das Messprinzip zur Bestimmung eines Spektrums des elektromagnetischen Messsignals.

Fig. 3    zeigt weitere Details des Photoleiters.

Fig. 4    zeigt ein Flussdiagramm eines Verfahrens zur Spektralanalyse des elektromagnetischen Messsignals gemäß der vorliegenden Erfindung.

## Detaillierte Beschreibung

Ausführungsbeispiele der vorliegenden Erfindung dienen der Analyse eines elektromagnetischen Messsignals mit einem unbekannten Spektrum, das eine oder mehrere unbekannte Frequenzen aufweisen kann.

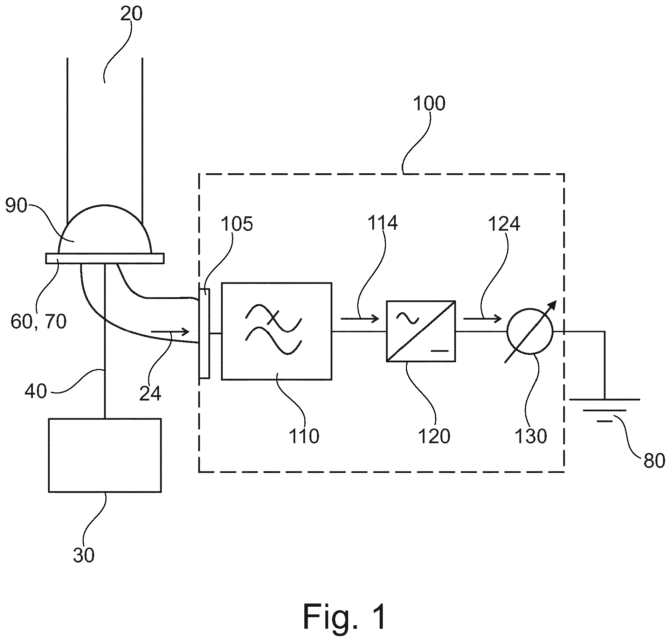

Fig. 1 zeigt eine solche Vorrichtung 100, die zur Spektralanalyse des elektromagnetischen Messsignals 20 unter Nutzung eines Photoleiters 60 (als ein Beispiel für einen opto-elektronischen Mischer) geeignet ist. Der Photoleiter 60 ist ausgebildet, um ein elektrisches Überlagerungssignal 24 durch eine Überlagerung des elektromagnetischen Messsignals 20 und eines optischen Referenzsignals 40 zu erzeugen, wobei das Referenzsignal zumindest eine bekannte Frequenz aufweist.

Die Vorrichtung 100 umfasst die folgenden Merkmale: ein Signaleingang 105, ein Tiefpassfilter 110, ein Gleichrichter 120 und eine Ausleseeinheit 130. Der Signaleingang 105 ist ausgebildet, um das elektrische Überlagerungssignals 24 von dem Photoleiter 60 zu empfangen. Der Tiefpassfilter 110 ist ausgebildet, um aus dem elektrischen Überlagerungssignal 24 ein gefiltertes Überlagerungssignal 114 durch ein Herausfiltern von Frequenzanteilen oberhalb einer oberen Grenzfrequenz zu erzeugen. Der Gleichrichter 120 ist ausgebildet, um aus dem gefilterte Überlagerungssignal 114 ein gleichgerichtetes Überlagerungssignal 124 zu erzeugen. Die Ausleseeinheit 130 ist ausgebildet, um basierend auf dem gleichgerichteten Überlagerungssignal 124 eine Übereinstimmung der bekannten Frequenz des Referenzsignals 40 mit dem elektromagnetischen Messsignal 20 oder mit einem Teil des elektromagnetischen Messsignals 20 festzustellen.

Die Vorrichtung 100 kann außerdem mit einem Masseanschluss 80 geerdet sein, so dass entsprechende Spannungen gegenüber der Masse gemessen werden können.

Der Signaleingang 105 erhält das elektrische Überlagerungssignal 24 von dem Photoleiter 60 beispielsweise über entsprechende Leitungen. Der Photoleiter 60 ist beispielsweise ausgebildet, um auf der einen Seite das elektromagnetische Messsignal 20 und auf der gegenüberliegenden Seite das Referenzsignal 40 zu empfangen. Das Referenzsignal 40 wird beispielsweise von einer Quelle (Referenzstrahlungsquelle) 30 erzeugt, kann aber auch durch Überlagerung von mehreren optischen Signalen von verschiedenen Quellen erzeugt werden. Die Quelle 30, die nicht notwendigerweise Teil der Vorrichtung 100 zur Spektralanalyse ist, kann beispielsweise eine oder mehrere Laserquellen oder einen Multimodenlaser umfassen, die als Referenzsignal 40 eine Überlagerung von einem oder mehreren Lasersignalen ausgeben.

Ein Photoleiter ist auch als Photowiderstand bekannt und ändert seinen elektrischen Widerstand in Abhängigkeit einer einfallen elektromagnetischen Strahlung. Häufig besteht er aus einem Halbleitermaterial, in welchem eine einfallende elektromagnetische Strahlung Elektron-Loch-Paare erzeugt und dadurch die Leitfähigkeit ändert. Wenn verschiedene Strahlungsquellen auf den Photoleiter einstrahlen, kommt es zu einer Überlagerung der einzelnen Signale. In dem Photoleiter 60 wird beispielsweise das Referenzsignal 40 mit dem elektromagnetischen Messsignal 20 überlagert und ein elektrisches Überlagerungssignal 24 an die Vorrichtung 100 ausgegeben.

Es ist vorteilhaft, wenn der Photoleiter 60 ausreichend schnell auf Veränderungen der Einstrahlcharakteristik reagiert, um so auch hochfrequente Signale zu erfassen. Daher kann der Photoleiter 60 dadurch charakterisiert sein, dass er eine Ladungsträgerlebensdauer von weniger als 500 ps oder weniger als 100 ps oder weniger als 50 ps oder weniger als 1 ps aufweist. Außerdem kann der Photoleiter 60 eine Antenne 70 umfassen, die ausgebildet ist, um das elektromagnetische Messsignal 20 möglichst effizient zu empfangen bzw. zu absorbieren. Optional kann der Photoleiter 60 auch eine Linse 90 umfassen, die ausgebildet ist, um das elektromagnetische Messsignal zu bündeln und auf einen sensitiven Bereich des Photoleiters 60 zu leiten.

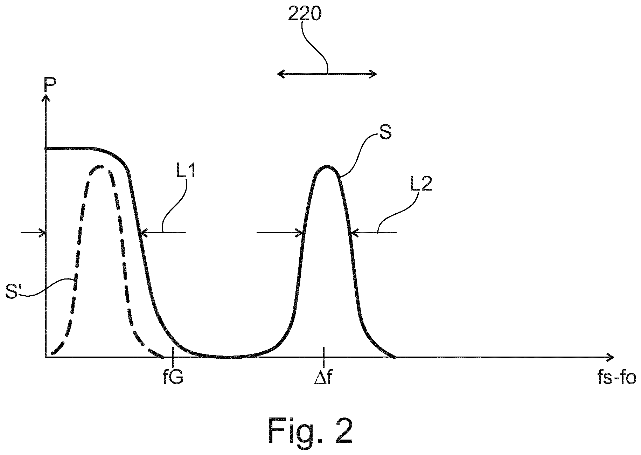

Fig. 2 veranschaulicht das Messprinzip zur Bestimmung, ob eine bestimmte Frequenz oder ein bestimmter Frequenzbereich in dem elektromagnetischen Messsignal 20 vorhanden ist oder nicht. Dargestellt ist eine spektrale Signalleistung P für einen Teil S des Überlagerungssignals 24 mit einer Mittenfrequenz $\Delta f$ und einer Linienbreite L2, wobei die Mittenfrequenz $\Delta f = fs-f0$ die Differenz aus der Frequenz des elektromagnetischen Messsignals 24 und der Referenzsignalfrequenz f0 ist. Da das Referenzsignal und seine Frequenz f0 bekannt sind, wird durch eine Analyse des Teils S eine Analyse des elektromagnetischen Messsignals 20 vorgenommen. Der Einfachheit halber ist nur ein Teil S gezeigt, wobei im Allgemeinen das Überlagerungssignals 24 noch weitere Frequenzanteile aufweist. Wie zuvor dargelegt, sind in dem Überlagerungssignal 24 außerdem mehrere Frequenzen überlagert: eine Referenzsignalfrequenz fo und die Frequenz fs des zu untersuchenden Messsignals 20, wobei die Vorrichtung aus Fig. 1 insbesondere sensitiv für die Frequenzdifferenz: fs-f0 ist. Der spektrale Frequenzsummenanteil weist eine so hohe Frequenz auf, dass sie durch das System nicht erfasst zu werden braucht.

Die unbekannte Frequenz fs des Messsignals 20 kann durch die Vorrichtung 100 wie folgt bestimmt werden.

Der Tiefpassfilter 110 filtert aus dem Überlagerungssignal 24 zunächst einen Frequenzanteil heraus, der unterhalb einer Grenzfrequenz fG liegt. Wenn beispielsweise der Teil S eine Frequenz $\Delta f > fG$ aufweist, wird der Tiefpassfilter 110 diesen Teil S herausfiltern. Das gefilterte Signal 114 umfasst dann das stets lediglich vorhandenes Rauschen.

Um die Frequenz fs (= $\Delta f + f0$) des Messsignals 20 zu bestimmen, kann die Referenzstrahlungsquelle 30 verstimmt werden, so dass sich f0 und somit die Frequenz $\Delta f$ des Überlagerungssignals 24 entsprechend ändert. Diese Bewegung des Teils S im Frequenzbereich ist durch den Doppelpfeil 220 dargestellt. Durch eine Verstimmung der Referenzstrahlungsquelle 30 wandert der Teil S des Überlagerungssignals 24 im Frequenzbereich somit entweder zu höheren oder zu tieferen Frequenzen - je nachdem, ob sich die Referenzsignalfrequenz f0 der Frequenz fs des Messsignals nähert oder sich weiter davon entfernt.

Wenn als Folge dieser Durchstimmung die Frequenz $\Delta f$ des Teils S' sich innerhalb des durch den Tiefpassfilter 110 bereitgestellten Frequenzbandes der Breite L1 ($\Delta f < fG$) befindet, wird als gefiltertes Signal 114 das entsprechende Messsignal S' ausgegeben und die Ausleseeinheit 130 kann ein entsprechendes Detektionssignal erzeugen. Dieses Detektionssignal deutet an, dass das elektromagnetische Messsignal 20 eine Frequenz fs aufweist, die (annähernd) gleich der bekannten Referenzsignalfrequenz f0 ist, und zwar bis auf eine Genauigkeit, die durch die Grenzfrequenz fG oder die Bandbreite des Tiefpassfilters 110 gegeben ist. Um eine möglichst hohe Genauigkeit zu erreichen, können beispielsweise die Linienbreite des Referenzsignals und die Bandbreite L1 des Tiefpassfilters 110 angepasst werden. Wenn die Breite L1 des Tiefpassfilters 110 entsprechend klein gewählt wird (beispielsweise in der Größenordnung der Linienbreite der Referenzsignalquelle), kann somit durch ein einfaches Detektieren eines diskreten Signals festgestellt werden, dass das elektromagnetische Messsignal 24 einen Frequenzanteil (oder eine Spektrallinie) mit einer Mittenfrequenz fo aufweist.

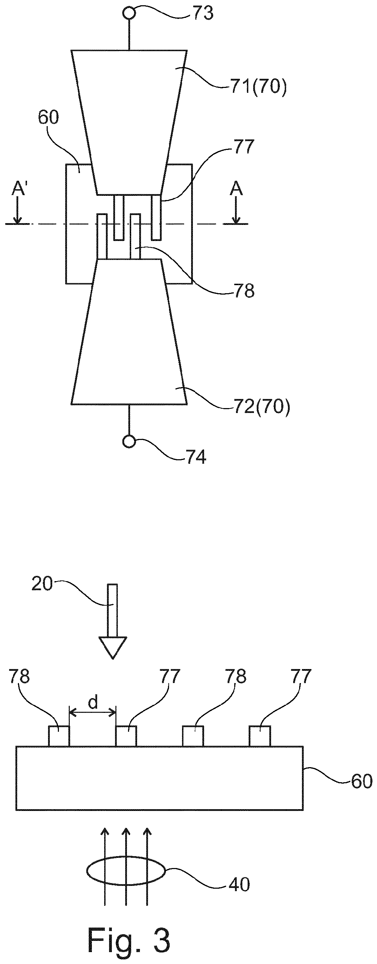

Fig. 3 zeigt weitere Details eines beispielhaften Photoleiters 60 und einer optionalen Antenne 70. Die Antenne 70 weist einen ersten Abschnitt 71 und einen zweiten Abschnitt 72 auf, die sich jeweils trapezförmig hin zu einem ersten Anschluss 73 und einem zweiten Anschluss 74 verbreitern. An der kürzeren Trapezseite weist der erste Abschnitt 71 eine erste Fingerkontaktstruktur mit mehreren Fingern auf. Ebenso weist der zweite Abschnitt 72 an der kürzeren Trapezseite eine zweite Fingerkontaktstruktur 78 mit mehreren Fingern auf. Die Fingerkontakte 77, 78 erstrecken sich ineinander mit einem Mindestabstand d (siehe Fig. 3 unten) und sind zusammen mit dem ersten Antennenabschnitt 71 und dem zweiten Antennenabschnitt 72 zumindest teilweise auf einem Halbleitersubstrat ausgebildet, welches den Photoleiter 60 bildet. Bei weiteren Ausführungsbeispielen ist Antennenformen nicht trapezförmig. Es versteht sich, dass die Erfindung nicht auf die gezeigte Trapezform eingeschränkt sein soll.

In der Fig. 3 unten ist eine Querschnittsansicht entlang der Querschnittslinie A'-A gezeigt, die durch das Halbleitermaterial des Photoleiters 60 führt und auf dessen Oberfläche sich die erste Fingerstruktur 77 und die zweite Fingerstruktur 78 erstrecken. Der Maximalabstand d zwischen den Fingern der ersten Fingerstruktur 77 und den Fingern der zweiten Fingerstruktur 78 kann beispielsweise so gewählt werden, dass eine möglichst effiziente Signalerfassung möglich ist. Beispielsweise kann dieser Abstand $d < 20\ \mu m$ sein (oder $d < 100\ \mu m$ oder $d < 50\ \mu m$ oder $d < 10\ \mu m$).

In dem gezeigten Ausführungsbeispiel wird das Referenzsignal 40 von einer Vorderseite auf das Halbleitersubstrat des Photoleiters 60 eingestrahlt, während das zu messende elektromagnetische Messsignal 20 beispielhaft auf eine Rückseite (d.h. den Elektrodenfingerstrukturen 77, 78 abgewandten Seite) eingestrahlt wird. Bei weiteren Ausführungsbeispielen kann jedoch die Einstrahlrichtung und/oder Einstrahlwinkel anders gewählt sein.

Die gezeigten Ausführungsbeispiele haben einen vergleichsweise einfachen Aufbau, der sich kostengünstig basierend auf bereits kommerziell verfügbaren Komponenten verwirklichen lässt. Dies bildet einen großen Vorteil der vorliegenden Erfindung im Vergleich zu den bekannten Systemen. Außerdem erlaubt das Durchstimmen der Referenzsignalquelle 30 ein Ermessen des Frequenzganges (Engl. sweep oscillator). Wenn beispielsweise das elektromagnetische Messsignal 20 eine Vielzahl von Linien in seinem Spektrum aufweist (oder auch ein kontinuierliches Spektrum hat), werden durch das Durchstimmen der Referenzsignalquelle 30 nacheinander die Linien als Signale detektiert (wenn die Linie in das Passband des Tiefpassfilters 110 gelangt). Jedem Verstimmungswert der Referenzsignalquelle 30 (d.h. einer bekannten Frequenz) kann somit einer Frequenzlinie in dem elektromagnetischem Messsignal 20 zugeordnet werden.

Das Referenzsignals 40 kann , wie bereits dargelegt, eine Überlagerung (Schwebung) von Signalen aus zwei beispielhaften Laserquellen sein, die jeweils in einem Wellenlängenbereich zwischen 500 und 1700 nm liegen können (oder zwischen 400 nm und 3000 nm liegen), so dass bei der Überlagerung die Differenzfrequenz zwischen den beiden Laserstrahlen eine Differenzfrequenz im Terahertz-Bereich entsteht, die für die vorliegende Messung genutzt wird. Weitere Ausführungsbeispiele beruhen beispielsweise auf ein modifiziertes Dauerstrich-Terahertzsystem mit zwei Dauerstrichlasern (beispielsweise zwei sogenannte DFB-Lasern; DFB = Distributed Feedback Laser), d.h. es wird die Laser-Dauerstrichtechnologie zur Erzeugung des Referenzsignals 40 genutzt. Für dieses System kann die Frequenzbestimmung wie folgt durchgeführt werden.

Beispielsweise können Lasersignale von zwei Laserquellen überlagert werden, deren Frequenzen

$$f_1,\ f_2 = f_1 + f_s + \Delta f$$

um das nachzuweisende Messsignal $f_s$ im Terahertzbereich bis auf eine kleine Abweichung $\Delta f$ verstimmt sind. Die Abweichung $\Delta f$ kann durch die Verstimmung der Laserquelle(n) gezielt eingestellt werden. Durch die Überlagerung der beiden Lasersignale entsteht eine Schwebung im optischen Signal bei der Differenzfrequenz gemäß:

$$P_L = 0.5 * P_0 * (1 + \cos \omega_{Lo} t)\ ,$$

wobei $\omega_{Lo} = 2\pi(f_2 - f_1)$ gilt. Das gemischte Lasersignal wird anschließend auf den Photoleiter 60 eingestrahlt und moduliert dadurch dessen Leitfähigkeit gemäß:

$$\sigma \sim P_L = 0.5 * P_0 * (1 + \cos \omega_{Lo} t)\ .$$

Der Photoleiter 60 empfängt mit seiner Antenne 70, die an das Halbleitersubstrat koppelt, außerdem das zu untersuchende Messsignal 20 mit einer Frequenz $f_s$. Zur verbesserten Ankopplung kann der Photoleiter 60 gemäß weiteren Ausführungsbeispielen eine Linse 90 (z.B. eine Siliziumlinse) oder ähnliche optische Bauelemente aufweisen, die beispielsweise der Bündelung des elektromagnetischen Messsignals 20 dienen. Das empfangene Messsignal 20 wird so in eine Spannung umgewandelt, dessen Stärke proportional zur empfangenen elektromagnetischen Feldstärke ist, wobei folgendes gilt:

$$U_{THz} \sim E_{THz}*\cos(\omega_s t + \varphi) \, ,$$

wobei $\omega_s = 2\pi f_s$ und $\varphi$ eine beliebige Phase ist.

Da beide Signale am Photoleiter 60 anliegen, entsteht somit ein Strom gemäß der folgenden Formel:

$$I \sim U_{THz}*\sigma \sim 0.5*P_0*E_{THz}*(1+\cos\omega_{L0}t)*\cos(\omega_s t + \varphi) \, .$$

Dieser Strom besitzt neben der Terahertzkomponente auch eine Komponente bei der Differenzfrequenz zwischen der Terahertzschwebung des optischen Signals und der Frequenz des zur charakterisierenden Messsignals

$$\Delta f = |f_{L0} - f_s| \, ,$$

wobei $f_{L0} = f_1 - f_2$ (entspricht dem zuvor definierten f0), die mit

$$I_{IF} \sim E_{THz}*\cos(2\pi\Delta f t + \varphi)$$

oszilliert.

Wenn beide Frequenzkomponenten sehr nahe beieinander liegen, ist die resultierende Frequenzkomponente $\Delta f$ sehr niederfrequent und kann prinzipiell mit einem RF Spektrumanalysator ausgelesen werden. Wenn beispielsweise die Frequenz fs des Signals unbekannt ist, kann somit nicht sichergestellt werden, dass der Frequenzbereich $\Delta f$ im Messbereich des RF Spektrumanalysators liegt. Infolgedessen muss die Differenzfrequenz der Laser verstimmt werden, um einen anderen Frequenzbereich zu analysieren und um erneut ein RF Spektrum aufzunehmen. Dies müsste für den gesamten THz Bereich iteriert werden und die erhaltenen Spektren zusammengefügt werden. Jedoch benötigt ein Spektrumanalysator eine gewisse Zeit zur Messung eines RF Spektrums, so dass die benötigte Messzeit sehr groß werden kann.

Diese Vorgehensweise ist aufwendig und wegen der vielen Schritte fehleranfällig. Viel einfacher ist es, wenn wie bei der vorliegenden Erfindung nur ein Signal auszuwerten wäre und nur die Differenzfrequenz der Laser durchgefahren werden müsste. Leider ist die relative Phase $\varphi$ zwischen der Schwebung auf dem Lasersignal und dem THz Signal nicht konstant, da beide Signale (das optische Lasersignal und das Messsignal) inkohärent zueinander sind. Die Phase $\varphi$ fluktuiert also beliebig, so dass keine einfach auszulesende Gleichspannungskomponente entsteht.

Die Gleichspannungskomponente kann gemäß Ausführungsbeispielen durch die Vorrichtung 100 wie folgt erzeugt werden (siehe auch Beschreibung zur Fig. 2).

Zunächst wird dem Photoleiter 60 ein optionaler Hochpassfilter mit relativ niedriger Passfrequenz (beispielsweise einige kHz) nachgeschaltet, um niederfrequentes Rauschen herauszufiltern. Anschließend folgt die Tiefpassfilterung mit dem Tiefpassfilter 110 mit einer Abschneidefrequenz fG z.B. im Bereich der Linienbreite der Laser (beispielsweise einige MHz), oder wahlweise auch mehr. Dadurch wird die Messbandbreite festgelegt. Hierbei ist es nicht wichtig, ob die Filterung tatsächlich durch den Filter 110 oder durch eine Maximalfrequenz eines eventuell nachfolgenden rauscharmen Verstärkers erfolgt. Der rauscharme Verstärker kann beispielsweise sinnvoll sein, um einen Vorverstärkung der häufig sehr kleinen Signale vorzunehmen. Dadurch wird ein besseres Signal zu Rauschverhältnis erreicht. Mit dem optionalen Hochpassfilter könnten als Mischer auch Photodioden (in verschiedensten Bauformen, z.B. Uni-travelling Carrier Photodioden) genutzt werden.

Das so bandgefilterte Signal 114 wird anschließend mittels eines Gleichrichters 120 (beispielsweise eine schnelle Diode oder mittels einer Operationsverstärkerschaltung, s.a. Fig. 1) gleichgerichtet, so dass ein positiv definiertes Signal 124 entsteht. Befindet sich das Messsignal 20 nun nahe der Differenzfrequenz der Laser und somit innerhalb des Bandfilters, entsteht durch die Gleichrichtung ein messbares Gleichspannungssignal, und zwar unabhängig von der willkürlichen Phase $\varphi$ zwischen dem Messsignal 20 und der Laserdifferenzfrequenz f0. Ist die Frequenz fs des Messsignals 20 zu weit von der Schwebungsfrequenz f0 des Lasers entfernt, filtert der Tiefpassfilter das Mischsignal (Teil S in Fig. 2) heraus und es wird nur das Rauschen im gewählten Passband gemessen.

Anschließend kann die Differenzfrequenz der Laser durchgestimmt werden und so der Gleichstromanteil nachgewiesen werden. Hierzu kann beispielsweise die sogenannte Lock-In Technik genutzt werden, wozu das Signal in diesem Fall noch zusätzlich zu modulieren wäre. Ein Vorteil dieser Vorgehensweise ist, dass nur ein Messpunkt pro Differenzfrequenz der Laser zu messen ist (der Messpunkt entspricht der Detektion des Gleichspannungssignals bei gegebener Referenzfrequenz, $f_{L0}$).

Diese Vorgehensweise, die mit der in der Fig. 2 dargestellten Vorgehensweise übereinstimmt, bietet die folgenden Vorteile:

- Sie ist deutlich einfacher, als jeweils ein RF Spektrum zu vermessen und auszuwerten. Ein weiterer Vorteil ergibt sich aus der Tatsache, dass nur ein Photomischer 60 notwendig ist, statt eines Photomischers zur THz Erzeugung und eines Detektors zur Mischung.
- Ein weiterer Vorteil von Ausführungsbeispielen besteht darin, dass das resultierende System im Wesentlichen kompatibel ist mit herkömmlichen Dauerstrich-Photomischsystemen und nur einen geringen Aufwand zur Modifikation des Spektrumanalysators erforderlich ist.
- Obwohl unter Umständen nur eine vergleichsweise geringe Frequenzauflösung, die beispielsweise im Bereich der Linienbreite des Lasers liegt (typischerweise einige MHz) erreichbar ist, bieten Ausführungsbeispiele eine schnelle und einfache Durchstimmbarkeit. Dadurch wird ein schnell arbeitender Spektralanalysator verwirklicht.
- Außerdem ist es möglich, extrem breitbandige THz Signale zu analysieren.
- Die Rauschgrenze ist bedingt durch die Materialqualität des Photoleiters und sollte im Bereich fW-pW/Hz für Frequenzen unterhalb von 1 THz liegen. Bei höheren Frequenzen steigt das Rauschen an. Trotzdem sollten aber weiterhin Messungen möglich sein, insofern das Messsignal stark genug ist.
- Da Dauerstrichlaser im Vergleich zu Frequenzkämmen sehr erschwinglich sind, nur ein THz Photomischer benötigt wird und keine RF Spektrumanalysatoren mit großen Messbandbreiten notwendig sind, ist das System vergleichsweise kostengünstig.

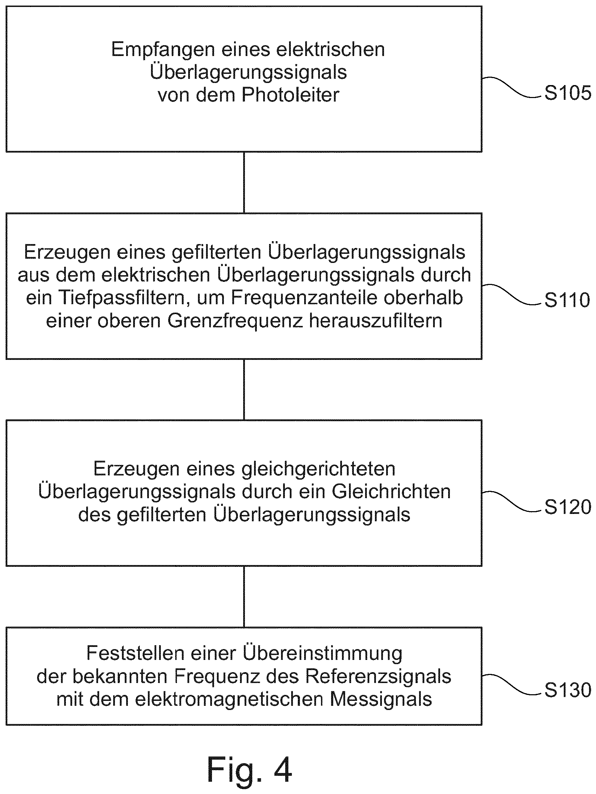

Fig. 4 zeigt ein Flussdiagram für ein Verfahren zur Spektralanalyse eines elektromagnetischen Messsignals 20 unter Nutzung eines Photoleiters 60, wobei der Photoleiter 60 ausgebildet ist, um das elektrische Überlagerungssignal 24 durch eine Überlagerung des elektromagnetischen Messsignals 20 und eines Referenzsignals 40 mit zumindest einer bekannten Frequenz f0 zu erzeugen. Das Verfahren umfasst die folgenden Schritte: Empfangen S105 eines elektrischen Überlagerungssignals 24 von dem Photoleiter 60, Erzeugen S110 eines gefilterten Überlagerungssignals 114 aus dem elektrischen Überlagerungssignal 24 durch ein Tiefpassfiltern um Frequenzanteile oberhalb einer oberen Grenzfrequenz fG herauszufiltern, Erzeugen S120 eines gleichgerichteten Überlagerungssignals 124 durch ein Gleichrichten gefilterten Überlagerungssignals 114, und Feststellen S130 einer Übereinstimmung der bekannten Frequenz f0 des Referenzsignals 40 mit dem elektromagnetischen Messsignal 20.

Alle zuvor beschriebenen Funktionen der Vorrichtungen können als weitere optionale Verfahrensschritte in dem Verfahren umgesetzt sein.

Das Verfahren kann zumindest teilweise auf einer Datenverarbeitungsanlage in Form von Software implementiert sein, die es ermöglicht, die Vorrichtung 100 bzw. das Referenzsignal 30 zu steuern. Weitere Ausführungsbeispiele umfassen daher auch ein Speichermedium mit einem darauf gespeicherten Computerprogramm, welches ausgebildet ist, um eine Vorrichtung zu veranlassen, das zuvor beschriebenes Verfahren auszuführen, wenn es auf einem Prozessor (Verarbeitungseinheit) läuft. Das Speichermedium kann ein maschinenlesbares Medium sein, das Mechanismus zum Speichern oder Übertragen von Daten in einer von einer Maschine (z.B. einem Computer) lesbaren Form beinhalten. Das software-implementiert Verfahren kann beispielsweise auf einem Steuermodul mit einem Prozessor implementiert sein, auf welchem das Computerprogramm läuft.

Bei weiteren Ausführungsbeispielen umfasst das System zwei Dauerstrich- oder Quasidauerstrichlasersignalen und außerdem einen ultraschnellen Photoleiter (beispielsweise mit einer Ladungsträgerlebensdauer von weniger als 100 ps). Erfindungsgemäß umfasst das System einen nachfolgenden Tiefpass 110 und einen nachfolgenden Gleichrichter 120, sowie eine Ausleseelektronik 130 für das gleichgerichtete Signal. Wenigstens einer der Laser ist durchstimmbar.

Bei einem weiteren Ausführungsbeispiel kann die Differenzfrequenz der Laser zwischen Gleichstrom bis zu maximal 10 THz durchgestimmt werden.

Bei einem weiteren Ausführungsbeispiel ist nach dem Photoleiter 60 oder nach dem Tiefpassfilter ein Verstärker ausgebildet.

Bei weiteren Ausführungsbeispielen ist der Tiefpassfilter 110 durch die Abschneidefrequenz eines Verstärkers realisiert.

Bei weiteren Ausführungsbeispielen ist der Tiefpassfilter 110 durchstimmbar.

Bei weiteren Ausführungsbeispielen liegt die Laserfrequenz im Bereich zwischen 500 und 1700 nm.

Bei weiteren Ausführungsbeispielen wird das Messsignal 20 zusätzlich moduliert und die Ausleseelektronik 130 basiert auf der Lock-In Technik.

Bei weiteren Ausführungsbeispielen verfügt der Photoleiter 60 über Fingerkontaktelektrodenstrukturen 77, 78 mit einem Abstand d von beispielsweise weniger als 20 $\mu$m.

Bei weiteren Ausführungsbeispielen ist der Photoleiter 60 an einer Antenne 70 gekoppelt.

Bei weiteren Ausführungsbeispielen ist der Photoleiter 60 auf einer Linse 90 angebracht.

Bei weiteren Ausführungsbeispielen ist zusätzlich ein Hochpassfilter zur Filterung niederfrequenter Anteile nach dem Photomischer 60 oder nach dem Tiefpass 110 oder nach dem Verstärker implementiert.

Bei weiteren Ausführungsbeispielen werden die Lasersignale durch einen multimodigen Laser erzeugt.

Bei weiteren Ausführungsbeispielen wird ein Dauerstrichfrequenzkamm als Laserquelle 30 verwendet.

Die in der Beschreibung, den Ansprüchen und den Figuren offenbarten Merkmale der Erfindung können sowohl einzeln als auch in beliebiger Kombination für die Verwirklichung der Erfindung wesentlich sein, limitiert durch den Umfang der angehängten Ansprüche.

Bezugszeichenliste

| | |
|---|---|
| 20 | elektromagnetisches Messsignal |
| 24 | elektrisches Überlagerungssignal |
| 30 | Quelle (Referenzstrahlungsquelle) |
| 40 | Referenzsignal |
| 60 | Photoleiter |
| 70, 71, 72 | Antenne |
| 73,74 | Antennenanschlüsse |
| 77, 78 | Fingerkontakte |
| 80 | Masseanschluss |
| 90 | Linse |
| 100 | Vorrichtung zur Spektralanalyse |
| 105 | Signaleingang |
| 110 | Tiefpassfilter |
| 114 | gefiltertes Überlagerungssignal |
| 120 | Gleichrichter |
| 124 | gleichgerichtetes Überlagerungssignal |
| 130 | Ausleseeinheit |
| 220 | Frequenzverschiebung eines spektralen Teils |
| f0 | Referenzsignalfrequenz |
| fs | Messsignalfrequenz |
| f1, f2 | Laserfrequenzen |
| fG | Grenzfrequenz |

**Patentansprüche**

1. Spektrumanalysator für ein elektromagnetisches Messsignal (20) mit einem unbekannten Spektrum,

umfassend zumindest eine Laserquelle (30), die ausgebildet ist, ein erstes Dauerstrichlasersignal mit einer ersten Frequenz (f1) und zweites Dauerstrichlasersignal mit einer zweiten Frequenz (f2) zu erzeugen und zu dem Referenzsignal (40) zu kombinieren, wobei die Laserquelle (30) durchstimmbar ist, um die erste Frequenz (f1) und/oder zweite Frequenz (f2) in einem vorbestimmten Bereich zu ändern, wobei der vorbestimmte Bereich insbesondere Frequenzen (fo) von 0 bis 10 THz umfasst,

einen opto-elektronischen Mischer (60), wobei der opto-elektronische Mischer (60) ausgebildet ist, um ein elektrisches Überlagerungssignal (24) durch Heruntermischung einer Überlagerung des elektromagnetischen Messsignals (20) und eines Referenzsignals (40) mit zumindest einer bekannten Frequenz (f0) zu erzeugen, wobei die bekannte Frequenz (f0) der Differenz der ersten Frequenz (f1) und der zweiten Frequenz (f2) entspricht;

einen Signaleingang (105) zum Empfangen des elektrischen Überlagerungssignals (24) von dem opto-elektronischen Mischer (60);

einen Tiefpassfilter (110), der ausgebildet ist, um aus dem elektrischen Überlagerungssignal (24) ein gefiltertes Überlagerungssignal (114) durch ein Herausfiltern von Frequenzanteilen oberhalb einer oberen Grenzfrequenz (fG) zu erzeugen;

einen Gleichrichter (120), der ausgebildet ist, um aus dem gefilterten Überlagerungssignal (114) ein gleichgerichtetes Überlagerungssignal (124) zu erzeugen; und

eine Ausleseeinheit (130), die ausgebildet ist, um basierend auf dem gleichgerichteten Überlagerungssignal (124) eine Übereinstimmung der bekannten Frequenz (f0) des Referenzsignals (40) mit dem elektromagnetischen Messsignal (20) festzustellen.

2. Spektrumanalysator nach Anspruch 1, der weiter einen Verstärker umfasst, um das elektrische Überlagerungssignal (24) oder das gefilterte Überlagerungssignal (114) zu verstärken.

3. Spektrumanalysator nach Anspruch 2, wobei der Tiefpassfilter (110) Teil des Verstärkers ist, so dass der Verstärker eine verringerte Verstärkung für Signals mit Frequenzen oberhalb der Grenzfrequenz (fG) aufweist.

4. Spektrumanalysator nach einem der vorhergehenden Ansprüche, wobei die Grenzfrequenz des Tiefpassfilters (110) regelbar ist.

5. Spektrumanalysator nach einem der vorhergehenden Ansprüche, der weiter zumindest eines aus dem Folgenden aufweist:

   einen Lock-in-Verstärker,
   einen Modulator, um das elektrischen Überlagerungssignal (24) mit einem Referenzsignal bekannter Frequenz und Phase zu modulieren, wobei die Ausleseeinheit (130) ausgebildet ist, um das modulierte elektrischen Überlagerungssignal basierend auf der Lock-In-Technik auszulesen.

6. Spektrumanalysator nach einem der vorhergehenden Ansprüche, der weiter einen Hochpassfilter umfasst, der ausgebildet ist, um Frequenzanteile des elektrischen Überlagerungssignals (24), die unterhalb einer unteren Grenzfrequenz liegen, herauszufiltern, wobei der Hochpassfilter entlang eines Signalpfades vor dem Gleichrichter (120) ausgebildet ist und der Gleichrichter (120) insbesondere einen Präzisionsgleichrichter oder eine Operationsverstärkerschaltung umfasst.

7. Spektrumanalysator nach einem der vorhergehenden Ansprüche, wobei die obere Grenzfrequenz (fG) des Tiefpassfilters (110) von einer Linienbreite des Referenzsignals (40) abhängt.

8. Spektrumanalysator nach einem der Ansprüche 1 bis 7, wobei das erste Lasersignal und/oder das zweite Lasersignal eine Wellenlänge in einem Bereich zwischen 500 nm und 1700 nm aufweisen.

9. Spektrumanalysator nach einem der vorhergehenden Ansprüche, wobei der opto-elektronische Mischer (60) als ein Photoleiter ausgebildet ist, der eine Fingerkontaktelektrodenstruktur (77, 78) mit einem Abstand (d) zwischen den Kontaktfingern von weniger als 20 $\mu$m aufweist.

10. Spektrumanalysator nach einem der vorhergehenden Ansprüche, wobei der opto-elektronische Mischer (60) weiter eine Antenne (70) zum Empfangen des elektromagnetischen Messsignals (20) und/oder eine Linse (90) zum Fokussieren des elektromagnetischen Messsignals (20) umfasst.

11. Spektrumanalysator nach einem der Ansprüche 1 bis 10, wobei die Laserquelle (30) zur Erzeugung des ersten Lasersignals und des zweiten Lasersignals eine Multimoden Laserquelle ist.

12. Verfahren zur Spektralanalyse eines elektromagnetischen Messsignals (20) mit unbekanntem Spektrum unter Nutzung eines Spektrumanalysators nach Anspruch 1, wobei das Verfahren die folgenden Schritte umfasst:

   Erzeugen des Überlagerungssignals (24) durch Überlagerung des Messsignals (20) und des Referenzsignals (40);
   Empfangen (S105) des elektrischen Überlagerungssignals (24) von dem opto-elektronischen Mischer (60);
   Erzeugen (S110) des gefilterten Überlagerungssignals (114) aus dem elektrischen Überlagerungssignal (24) durch Tiefpassfiltern mit dem Tiefpassfilter (110), um Frequenzanteile oberhalb der oberen Grenzfrequenz (fG) herauszufiltern;
   Erzeugen (S120) des gleichgerichteten Überlagerungssignals (124) durch Gleichrichten des gefilterten Überlagerungssignals (114) mit dem Gleichrichter (120); und Feststellen (S130) einer Übereinstimmung der bekannten Frequenz des Referenzsignals (40) mit dem elektromagnetischen Messsignal (20).

13. Verfahren nach Anspruch 12, wobei das Referenzsignal (40) eine Schwebung von zwei Lasersignalen, die von einer oder mehreren Laserquellen (30) erzeugt werden, aufweist und das Verfahren weiter Folgendes umfasst:

   Durchstimmen von zumindest einer der Laserquellen (30) bis eine Frequenz ($\Delta$f) eines Teils (S) des Überlagerungssignals (24) unterhalb der Grenzfrequenz (fG) liegt; und

Feststellen, dass das Messsignal (20) die Frequenz (f0) aufweist.

**14.** Speichermedium mit einem darauf gespeicherten Computerprogramm, welches ausgebildet ist, das Verfahren nach Anspruch 12 auf der Vorrichtung nach Anspruch 1 auszuführen.

**Claims**

**1.** Spectrum analyzer for an electromagnetic measurement signal (20) having an unknown spectrum,

comprising
at least one laser source (30), configured to generate a first continuous wave laser signal with a first frequency (f1) and second continuous wave laser signal with a second frequency (f2), and to combine them with the reference signal (40), wherein the laser source (30) is tunable to change the first frequency (f1) and/or second frequency (f2) in a predetermined range, the predetermined range comprising in particular frequencies (fo) from 0 to 10 THz,
an opto-electronic mixer (60), wherein the opto-electronic mixer (60) is configured to generate an electrical superposition signal (24) by downmixing a superposition of the electromagnetic measurement signal (20) and a reference signal (40) with at least one known frequency (f0), wherein the known frequency (f0) corresponds to the difference of the first frequency (f1) and the second frequency (f2);
a signal input (105) for receiving the electrical superposition signal (24) from the opto-electronic mixer (60);
a low-pass filter (110) configured to generate a filtered superposition signal (114) from the electrical superposition signal (24) by filtering out frequency portions above an upper cut-off frequency (fG);
a rectifier (120) configured to generate a rectified superposition signal (124) from the filtered superposition signal (114); and
a readout unit (130) configured to determine a match of the known frequency (f0) of the reference signal (40) with the electromagnetic measurement signal (20) based on the rectified superposition signal (124).

**2.** Spectrum analyzer according to claim 1, further comprising an amplifier to amplify the electrical superposition signal (24) or the filtered superposition signal (114).

**3.** Spectrum analyzer according to claim 2, wherein the low pass filter (110) is part of the amplifier so that the amplifier has a reduced gain for signals with frequencies above the cut-off frequency (fG).

**4.** Spectrum analyzer according to any one of the preceding claims, wherein the cut-off frequency of the low-pass filter (110) is adjustable.

**5.** Spectrum analyzer according to any one of the preceding claims, further comprising at least one of the following:

a lock-in amplifier,
a modulator to modulate the electrical superposition signal (24) with a reference signal of known frequency and phase, wherein the readout unit (130) is configured to read out the modulated electrical superposition signal based on the lock-in technique.

**6.** Spectrum analyzer according to any one of the preceding claims, further comprising a high-pass filter configured to filter out frequency portions of the electrical superposition signal (24) that are below a lower cut-off frequency, wherein the high-pass filter is located along a signal path before the rectifier (120), and wherein the rectifier (120) comprises in particular a precision rectifier or an operational amplifier circuit.

**7.** Spectrum analyzer according to any one of the preceding claims, wherein the upper cut-off frequency (fG) of the low-pass filter (110) depends on a line width of the reference signal (40).

**8.** Spectrum analyzer according to any one of the claims 1 to 7, wherein the first laser signal and/or the second laser signal have a wavelength in a range between 500 nm and 1700 nm.

**9.** Spectrum analyzer according to any one of the preceding claims, wherein the opto-electronic mixer (60) is formed as a photoconductor comprising a finger contact electrode structure (77, 78) with a distance (d) between the contact fingers of less than 20 $\mu$m.

**10.** Spectrum analyzer according to any one of the preceding claims, wherein the opto-electronic mixer (60) further comprises an antenna (70) for receiving the electromagnetic measurement signal (20) and/or a lens (90) for focusing the electromagnetic measurement signal (20).

**11.** Spectrum analyzer according to any one of the claims 1 to 10, wherein the laser source (30) for generating the first laser signal and the second laser signal is a multimode laser source.

**12.** Method for spectral analysis of an electromagnetic measurement signal (20) with unknown spectrum using a spectrum analyzer according to claim 1, wherein the method comprises the following steps:

generating the superposition signal (24) by superimposing the measurement signal (20) and the reference signal (40);
receiving (S105) the electrical superposition signal (24) from the opto-electronic mixer (60);
generating (S110) the filtered superposition signal (114) from the electrical superposition signal (24) by low-pass filtering with the low-pass filter (110) in order to filter out frequency portions above the upper cut-off frequency (fG);
generating (S120) the rectified superposition signal (124) by rectifying the filtered superposition signal (114) with the rectifier (120); and
detecting (S130) a correspondence of the known frequency of the reference signal (40) with the electromagnetic measurement signal (20).

**13.** The method according to claim 12, wherein the reference signal (40) comprises a beat of two laser signals generated by one or more laser sources (30), and the method further comprises:

tuning at least one of the laser sources (30) until a frequency (Δf) of a portion (S) of the superposition signal (24) is below the cut-off frequency (fG); and
determining that the measurement signal (20) comprises the frequency (f0).

**14.** Storage medium with a computer program stored thereon, which is configured to carry out the method according to claim 12 on the device according to claim 1.

**Revendications**

**1.** Analyseur de spectre pour un signal de mesure électromagnétique (20) ayant un spectre inconnu,

comprenant
au moins une source laser (30) qui est conçue pour générer un premier signal laser à onde continue avec une première fréquence (f1) et un deuxième signal laser à onde continue avec une deuxième fréquence (f2) et pour les combiner au signal de référence (40), la source laser (30) étant accordable pour modifier la première fréquence (f1) et/ou la deuxième fréquence (f2) dans une plage prédéterminée, la plage prédéterminée comprenant en particulier des fréquences (fo) de 0 à 10 THz,
un mélangeur opto-électronique (60), le mélangeur opto-électronique (60) étant adapté pour générer un signal électrique de superposition (24) en sous-mélangeant une superposition du signal électromagnétique de mesure (20) et d'un signal de référence (40) ayant au moins une fréquence connue (f0), la fréquence connue (f0) correspondant à la différence entre la première fréquence (f1) et la deuxième fréquence (f2) ;
une entrée de signal (105) pour recevoir le signal électrique de superposition (24) provenant du mélangeur opto-électronique (60) ;
un filtre passe-bas (110) conçu pour produire, à partir du signal électrique de superposition (24), un signal de superposition filtré (114) par filtrage des composantes de fréquence supérieures à une fréquence de coupure supérieure (fG) ;
un redresseur (120) conçu pour générer un signal de superposition redressé (124) à partir du signal de superposition filtré (114) ; et
une unité de lecture (130) qui est conçue pour déterminer, sur la base du signal de battement redressé (124), une concordance de la fréquence connue (f0) du signal de référence (40) avec le signal de mesure électromagnétique (20).

**2.** Analyseur de spectre selon la revendication 1, comprenant en outre un amplificateur pour amplifier le signal électrique de superposition (24) ou le signal de superposition filtré (114).

3. Analyseur de spectre selon la revendication 2, dans lequel le filtre passe-bas (110) fait partie de l'amplificateur, de sorte que l'amplificateur présente un gain réduit pour les signaux ayant des fréquences supérieures à la fréquence de coupure (fG).

4. Analyseur de spectre selon l'une des revendications précédentes, dans lequel la fréquence de coupure du filtre passe-bas (110) est réglable.

5. Analyseur de spectre selon l'une des revendications précédentes, comprenant en outre au moins un des éléments suivants :

un amplificateur à verrouillage,
un modulateur pour moduler le signal électrique de superposition (24) avec un signal de référence de fréquence et de phase connues, l'unité de lecture (130) étant conçue pour lire le signal électrique de superposition modulé sur la base de la technique de verrouillage.

6. Analyseur de spectre selon l'une des revendications précédentes, comprenant en outre un filtre passe-haut configuré pour filtrer les composantes fréquen-tielles du signal électrique de superposition (24) qui sont inférieures à une fréquence de coupure inférieure, le filtre passe-haut étant configuré le long d'un chemin de signal en amont du redresseur (120), et le redresseur (120) comprenant notamment un redresseur de précision ou un circuit amplificateur opérationnel.

7. Analyseur de spectre selon l'une des revendications précédentes, dans lequel la fréquence de coupure supérieure (fG) du filtre passe-bas (110) dépend d'une largeur de raie du signal de référence (40).

8. Analyseur de spectre selon l'une des revendications 1 à 7, dans lequel le premier signal laser et/ou le deuxième signal laser ont une longueur d'onde comprise dans une plage allant de 500 nm à 1700 nm.

9. Analyseur de spectre selon l'une des revendications précédentes, dans lequel le mélangeur optoélectronique (60) est réalisé sous la forme d'un photoconducteur présentant une structure d'électrodes de contact à doigts (77, 78) avec une distance (d) entre les doigts de contact inférieure à 20 $\mu$m.

10. Analyseur de spectre selon l'une des revendications précédentes, dans lequel le mélangeur optoélectronique (60) comprend en outre une antenne (70) pour recevoir le signal de mesure électromagnétique (20) et/ou une lentille (90) pour focaliser le signal de mesure électromagnétique (20).

11. Analyseur de spectre selon l'une des revendications 1 à 10, dans lequel la source laser (30) pour générer le premier signal laser et le deuxième signal laser est une source laser multimode.

12. Procédé d'analyse spectrale d'un signal de mesure électromagnétique (20) de spectre inconnu utilisant un analyseur de spectre selon la revendication 1, ledit procédé comprenant les étapes suivantes :

générer le signal de superposition (24) en superposant le signal de mesure (20) et le signal de référence (40) ;
récevoir (S105) le signal électrique de superposition (24) en provenance du mélangeur opto-électronique (60) ;
générer (S110) le signal électrique de superposition filtré (114) à partir du signal électrique de superposition (24) par filtrage passe-bas avec le filtre passe-bas (110) afin de filtrer les composantes de fréquence supérieures à la fréquence de coupure supérieure (fG) ;
générer (S120) le signal de superposition redressé (124) en redressant le signal de superposition filtré (114) avec le redresseur (120) ; et
déterminer (S130) une correspondance entre la fréquence connue du signal de référence (40) et le signal de mesure électromagnétique (20).

13. Procédé selon la revendication 12, dans lequel le signal de référence (40) comprend un battement de deux signaux laser générés par une ou plusieurs sources laser (30), le procédé comprenant en outre les étapes consistant à :

accorder au moins une des sources laser (30) jusqu'à ce qu'une fréquence ($\Delta$f) d'une partie (S) du signal de battement (24) soit inférieure à la fréquence de coupure (fG) ; et

déterminer que le signal de mesure (20) présente la fréquence (f0).

14. Support de stockage sur lequel est stocké un programme d'ordinateur adapté pour mettre en oeuvre le procédé selon la revendication 12 sur le dispositif selon la revendication 1.

Fig. 1

Fig. 2

Fig. 3

Empfangen eines elektrischen
Überlagerungssignals
von dem Photoleiter — S105

Erzeugen eines gefilterten Überlagerungssignals
aus dem elektrischen Überlagerungssignals durch
ein Tiefpassfiltern, um Frequenzanteile oberhalb
einer oberen Grenzfrequenz herauszufiltern — S110

Erzeugen eines gleichgerichteten
Überlagerungssignals durch ein Gleichrichten
des gefilterten Überlagerungssignals — S120

Feststellen einer Übereinstimmung
der bekannten Frequenz des Referenzsignals
mit dem elektromagnetischen Messignals — S130

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69125254 T2

- US 2012044479 A1

**In der Beschreibung aufgeführte Nicht-Patentliteratur**

- **SHUKO YOKOYAMA et al.** Terahertz spectrum analyzer based on a terahertz frequency comb. *Optics Express,* vol. 16 (17, 18), 13052

- **PREU S.** Tunable, continuous-wave Terahertz photomixer sources and applications. *JOURNAL OF APPLIED PHYSICS,* 22. Marz 2011, vol. 109 (6